# EUROPEAN PATENT SPECIFICATION

(11) **EP 2 919 568 B1**
(45) Date of publication and mention of the grant of the patent: **31.08.2016**
(21) Application number: 14190023.3
(22) Date of filing: 23.10.2014
(51) Int. Cl.: H05K 5/06, H03K 17/95, G01D 11/24

(54) **Electronic device**
Elektronische Vorrichtung
Dispositif électronique

(30) Priority: 14.03.2014 JP 2014051626
(43) Date of publication of application: 16.09.2015
(73) Proprietor: OMRON CORPORATION, Kyoto, Kyoto 600-8530 (JP)
(72) Inventor: Nishikawa, Kazuyoshi, Kyoto, Kyoto 600-8530 (JP)
(74) Representative: Horn Kleimann Waitzhofer Patentanwälte PartG mbB

(56) References cited:
- EP-A2- 0 289 956
- JP-A- H06 103 869
- US-A1- 2010 327 855

## Description

### FIELD

The present invention generally relates to an electronic device, and in particular to an electronic device that has a structure in which a circuit board is accommodated in a case.

### BACKGROUND

Conventional electronic devices encompass an electronic device that protects a circuit board in a case from application of a stress that is generated by contraction and expansion of a resin with which the case is filled due to a temperature change (see, for example, JP H06-103869A).

In a proximity sensor that serves as the electronic device disclosed in JP H06-103869A, the circuit board is accommodated in a protective cover and the proximity sensor is filled with an insulating resin. By accommodating the circuit board in the protective cover and then injecting the insulating resin from a gap between the cover with a flange and the case, the circuit board in the case is protected from application of stress due to contraction and expansion of the resin.

JP H06-103869A is an example of background art.

### SUMMARY

As disclosed in the above-described JP H06-103869A, a structure in which a circuit board of a proximity sensor is accommodated in a protective cover in order to be protected from application of a stress is known. However, even in such a structure, a seal between a main case and a cord that is connected to the circuit board accommodated in the main case is only achieved by adhesion to the resin with which the main case is filled, and there is the problem that, due to expansion and contraction of the resin with which the main case is filled under an environment of repeated heating cycles, the corresponding components may be detached from each other and, for example, water may enter from a gap between the cord and the resin, resulting in deterioration in water resistance.

It is therefore an object of the present invention to solve the above-described problem, and to provide an electronic device that improves the water resistance.

An electronic device according to one aspect of the present invention includes: a tubular case; a front end member that is accommodated in the tubular case on one end thereof, and closes the one end; a circuit board that is fixed to the front end member; a cord that includes a core wire and a coating material for coating the core wire, the core wire being exposed from one end of the coating material; an inner case that is accommodated in the tubular case and is tubular, and whose one end is in contact with the front end member, the inner case accommodating the circuit board; and a resin section that watertightly covers a section in which the front end member and the inner case are in contact with each other. Furthermore, the core wire is connected to the circuit board, the cord passes through the other end of the inner case and comes out from the other end of the tubular case to the outside of the tubular case, and the inner case and the coating material are welded over the entire circumference of the coating material.

According to the electronic device having such a configuration, it is possible to prevent deterioration in water resistance property due to detachment of the cord from the resin by welding the inner case and the coating material over the entire circumference of the coating material.

Furthermore, it is preferable that the inner case includes an extension section that extends cylindrically and accommodates the circuit board, and includes a small diameter section whose inner diameter decreases in a direction from an edge of the extension section toward the cord that is located through the small diameter section, the inner diameter of the small diameter section and the coating material are welded over the entire circumference of the coating material. According to the electronic device having such a configuration, it is possible to manufacture by integral molding, the inner case that includes fewer number of constituent components and has excellent water resistance.

Furthermore, it is preferable that the inner case includes an extension section that extends cylindrically and accommodates the circuit board, the extension section has, on a part of an outer circumference thereof, a large diameter section whose outer diameter increases toward an inner circumferential surface of the tubular case, and the large diameter section is in contact with the inner circumferential surface of the tubular case. According to the electronic device having such a configuration, it is possible to fix the inner case and the tubular case without a space between the inner case and the tubular case being filled with a resin, preventing deterioration in water resistance property.

Furthermore, it is preferable that the inner case includes an extension section that extends cylindrically and accommodates the circuit board, the extension section has, on a part of a cylindrical outer circumference thereof, a large diameter section whose outer diameter increases toward the inner circumferential surface of the tubular case, and the outer diameter of the large diameter section is smaller than an inner diameter of the tubular case. According to the electronic device having such a configuration, it is possible to fix the inner case and the tubular case by compression, laser-welding, an adhesive agent, engagement, or the like while preventing deterioration in water resistance property.

Furthermore, it is preferable that a space between the inner case and the tubular case is filled with a resin. According to the electronic device having such a configuration, it is possible to improve the seal stability as compared with the case where only the section in which the front end member and the inner case are in contact with each other is covered with a resin.

Furthermore, it is preferable that the resin section is made of a thermosetting resin. According to the electronic device having such a configuration, it is possible to provide an electronic device that prevents deterioration in water resistance property, since a resin does not move even when the electronic device is used in a high temperature environment.

Furthermore, it is preferable that the cord is welded, over the entire circumference of the coating material, to the inside of the inner case by 1 mm or more in a direction in which the cord extends to the other end of the tubular case. According to the electronic device having such a configuration, it is possible to improve the seal stability between the inner case and the coating material.

Furthermore, it is preferable that a distance between an outer circumferential surface of the inner case and the inner circumferential surface of the tubular case is 0.8 mm or more to 4.5 mm or less.

According to the electronic device having such a configuration, it is possible to suppress insufficient filling with a resin due to a resin injection trouble, a shrinkage cavity due to a resin contraction stress, and the risk of deficiency in water resistance due to detachment or crack occurrence.

Furthermore, in the case where the present invention is applied to a proximity sensor, the proximity sensor is an electronic device according to the one aspect of the present invention, wherein the front end member serves as a front end case, and the front end case accommodates a detecting unit that includes a core body on which a coil wire is wound.

According to the proximity sensor having such a configuration, by welding the inner case and the coating material over the entire circumference of the coating material, it is possible to prevent deterioration in water resistance property due to detachment of the cord from the resin.

As described above, according to the present invention, it is possible to provide an electronic device that improves the water resistance.

### BRIEF DESCRIPTION OF THE DRAWINGS

FIG. 1 is a perspective view illustrating a proximity sensor according to an embodiment of the present invention.
FIG. 2 is a cross-sectional view taken along the line III - III of FIG. 1.
FIGS. 3 are diagrams illustrating a method for manufacturing the proximity sensor.
FIGS. 4 are diagrams illustrating a method for manufacturing a proximity sensor that has another configuration.

### DETAILED DESCRIPTION

Hereinafter, an embodiment of the present invention will be described in detail with reference to the accompanying drawings.

### (Description of Embodiment)

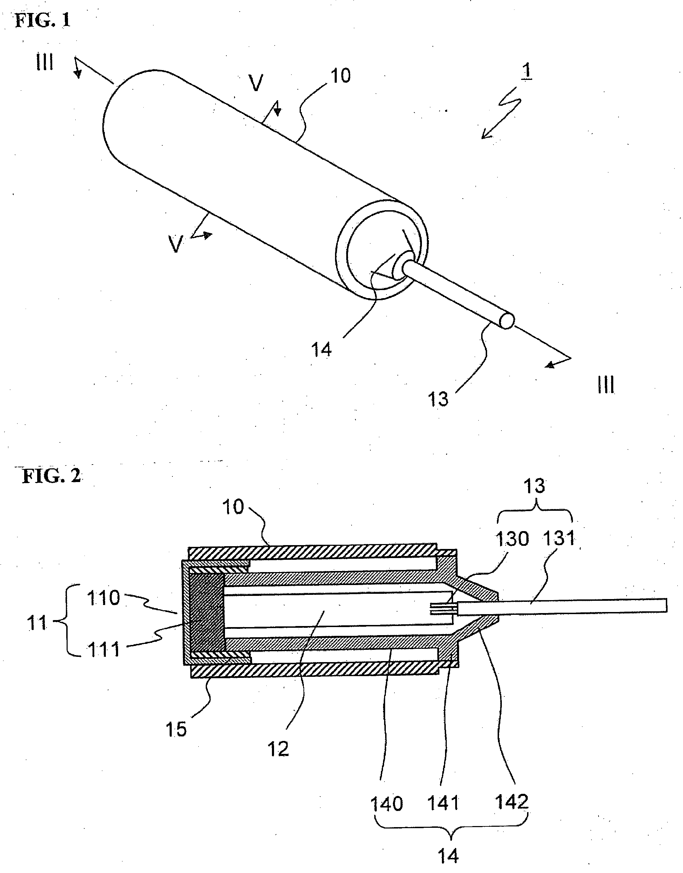

First, a proximity sensor 1 according to the present embodiment will be described with reference to FIGS. 1 to 2. FIG. 1 is a perspective view illustrating the proximity sensor 1 of the present embodiment. FIG. 2 is a cross-sectional view taken along the line III-III of FIG. 1. Note that a cord is shown in a side view.

The proximity sensor 1 of the present embodiment includes a tubular case 10, a front end member 11, a circuit board 12, a cord 13, an inner case 14, and a resin section 15.

The tubular case 10 needs only to be tubular, and the shape thereof is not particularly limited and may be, for example, that of a cylinder or a prism. The tubular case 10 is made from metal. Alternatively, the tubular case 10 may also be made from a resin member. The material of such a resin may appropriately be selected from, for example, PEEK (polyether ether ketone), PBT (polybutylene terephthalate), ABS, and the like.

The front end member 11 includes a front end case 110 that is accommodated in the tubular case 10 on one end thereof and closes the one end, and a detection unit 111 that is accommodated in the front end case 110 and has a core body on which a coil wire is wound. Hereinafter, these components will be described.

The detection unit 111 detects whether or not a detection target is approaching or present. For example, the detection unit 111 generates a magnetic field by flowing a current through the coil, and detects whether or not a detection target is approaching or present using an electromagnetic interaction between the generated magnetic field and the detection target. The detection unit 111 and the circuit board 12 are electrically connected to each other. The circuit board 12 includes an oscillation circuit that flows a current through the detection unit 111, and a detection circuit that detects whether or not an object is approaching based on a change in oscillation output due to electromagnetic interaction. Furthermore, the circuit board 12 is electrically connected to a cord 13, which will be described later, and outputs an object detection signal to the outside using the cord 13.

The detection unit 111 is provided on the front end side of the proximity sensor 1 that faces a detection region. The detection unit 111 mainly includes a core, an electromagnetic coil, and a coil spool, although they are not shown.

The core is made from a made from, for example, a material having an excellent high frequency property, such as ferrite. The core has the function to increase the coil characteristics (e.g. inductivity) of the detection unit 111, and to concentrate magnetic fluxes in the detection region.

The electromagnetic coil is a coil wire and wound on the coil spool. The electromagnetic coil is wound around the central axis of the tubular case 10.

The coil spool is made from an electric insulating resin. The coil spool is accommodated in a circular groove formed in the core. A coil pin is made from conductive metal. The coil pin is supported by the coil spool. The coil pin extends from the detection unit 111 to the circuit board 12 side. The end of the extending coil pin is connected to a conductive region formed on the circuit board 12.

A top of the electromagnetic coil that is drawn from the outer circumference of the coil spool is wound around the root section of the coil pin that extends from the detecting unit 111. The electromagnetic coil and the circuit board 12 are electrically connected to each other via the coil pin and solder.

The detection unit 111 is accommodated in the front end case 110. The front end case 110 functions as a front cover that is mounted in the opening on the front end side of the tubular case 10. The front end case 110 is typically made from a material such as a thermoplastic resin that has an excellent adhesive property to the resin section. A material of the front end case 110 may appropriately be selected from, for example, ABS, PC (polycarbonate), POM (polyacetal), PBT (polybutylene terephthalate), PA (polyamide), PE (polyethylene), PP (polypropylene), PES (polyether sulfone), PPS (Polyphenylenesulfide), LCP (liquid crystal polymer), and PS (polystyrene), and mixtures thereof.

The front end case 110 is provided so as to serve as a cover for the front end side in which the detection unit 111 is accommodated. The front end case 110 closes the opening on the front end side of the tubular case 10, which serves as the main case. The front end case 110 is mainly provided to blocking and protecting the detection unit 111 from the outer atmosphere.

The front end case 110 cylindrically extends coaxially with the central axis of the tubular case 10, and has a shape in which one end thereof is closed and the other end thereof is open. The end face of the front end case 110 on the closed end side constitutes a detection surface of the proximity sensor 1. The detection unit 111 is arranged inside the tubular section of the front end case 110.

The circuit board 12 is a substrate on which electronic components, such as a transistor, a diode, a resistor, a capacitor, and an integrated circuit (IC), are mounted. The circuit board 12 is electrically connected to the detection unit 111. The electronic components of the circuit board 12 constitute the oscillation circuit that flows a current through the detection unit 111, and the detection circuit that detects whether or not an object is approaching based on a change in oscillation output due to electromagnetic interaction. Furthermore, the circuit board 12 is electrically connected to the cord 13, which will be described later, and outputs an object detection signal that is input from the detection unit 111 to the outside, using the cord 13.

The cord 13 has core wires 130 and a coating material 131 that coats the core wires 130. The core wires 130 are each obtained by, for example, a conductive wire being coated with an insulating material, and are connected to the circuit board 12 by soldering (not shown). The material of the coating material is mainly selected from synthetic resins. The synthetic resin is selected from, for example, PVC (polyvinyl chloride) and PUR (polyurethane). The configuration (the number of core wires and the diameter of the cord) of the cord may be selected as appropriate.

The inner case 14 includes an extension section 140 that has a smaller diameter than the front end case 110 and extends cylindrically and coaxially with the central axis of the tubular case 10, a large diameter section 141 whose diameter increases, on one end of the extension section 140, toward the inner wall surface of the tubular case 10, and that has the shape of a cylinder obtained by rotation around the central axis of the tubular case 10, with the central axis taken as the axis of symmetry, and a small diameter section 142 whose diameter decreases toward the cord 13 that passes through the other end of the inner case 14 from the inside thereof and comes out to the outside of the tubular case 10.

The extension section 140 is accommodated in the tubular case 10, and one end of the extension section 140 is in contact with the front end member 11. The tubular case 10 accommodates the circuit board 12, and the small diameter section 142 is welded to the coating material 131 of the cord 13, which will be described later, over the entire circumference of the coating material 131.

The inner case 14 may be made from any of metal and a resin, but may preferably be made from a thermoplastic resin in view of the degree of freedom of design, and the cost. The material may be selected from PBT, PP, ABS, and the like.

Furthermore, the internal space of the inner case 14 needs only to be configured to accommodate the circuit board 12, and may also include a structure for holding the circuit board 12. For example, a hole that has substantially the same thickness and width as the circuit board 12 and that extends in the axial direction of the inner case 14 may be formed in the inner case 14, the hole serving as a circuit board holding space.

When the extension section 140 of the inner case 14 is arranged so as to be in contact with the detection unit 111 accommodated in the front end case 110, a space formed between the front end case 110, and the detection unit 111 and the inner case 14 is filled with the resin section 15, and the resin section 15 watertightly covers the section in which the front end member 11 and the inner case14 are in contact with each other. The resin section 15 has the function to prevent water from entering from the space between the front end member 11 and the inner case 14. Furthermore, a space between the inner case 14 and the tubular case 10 may be filled with a resin. The resin section 15 may be made of a thermoplastic resin (so-called hot melt resin), but is preferably a thermosetting resin in view of water resistance. The thermosetting resin may typically be an epoxy resin. The thermosetting resin for use in formation of the resin section 15 may also include various types of additive agents such as a flame retarder, an organic/inorganic filler, a plasticizer, a coloring agent, and an antioxidant.

The cord 13 passes through the small diameter section 142 of the inner case 14, and comes out from the other end of the tubular case 10 to the outside of the tubular case 10. By welding the inner case 14 and the coating material 131 over the entire circumference of the coating material 131, it is possible to prevent water resistance from deteriorating due to detachment of the cord 13 from the resin. Note that any method may be used for a welding method as long as it is a method in which both the cord 13 and the inner case 14 are melted and adhered to each other by integral molding, laser welding, ultrasonic welding, or the like. Furthermore, in view of improvement in seal stability, welding of the cord 13 and the inner case 14 is preferably such that the cord 13 is welded to the small diameter section of the inner case by 1 mm or more in the direction in which the cord 13 extends toward the other end of the tubular case 10, over the entire circumference of the coating material 131.

Since, here, the proximity sensor 1 is described as an embodiment, the front end member 11 is constituted by the front end case 110 that is accommodated in the tubular case 10 on one end thereof and closes the one end, and the detection unit 111 that is accommodated in the front end case 110 and has the core body on which a coil wire is wound. In the case of another electronic device, the front end member needs only to be a member that can close an opening of a tubular case, which serves as a main case.

### (Manufacturing Method)

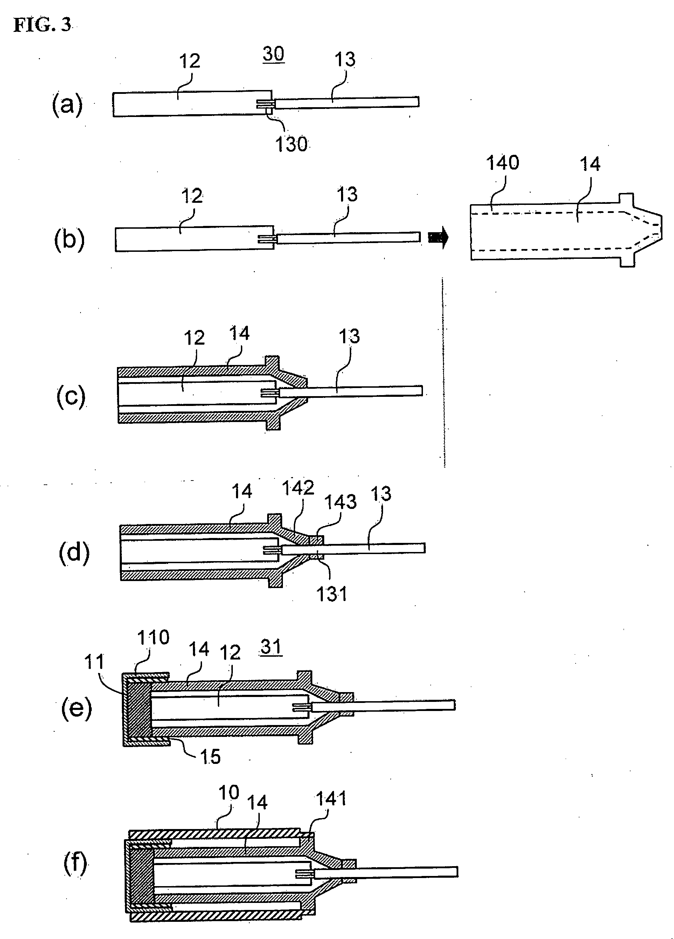

A method for manufacturing the proximity sensor 1 according to the present embodiment will be described with reference to FIG. 3. Note that FIGS. 3(a) and 3(b) show side views, and FIGS. 3(c) to 3(f) show cross-sectional views taken along the line III-III of FIG. 1. Note that, in FIGS. 3(c) to 3(f), only the cord 13 is shown in side views. First, a sub-assembly A30 that includes the cord 13 and the circuit board 12 is assembled. Specifically, although not shown, the core wires 130 in the top end section of the cord 13 are stripped and conductive wire sections of the core wires 130 are soldered and mounted on the surface of the circuit board 12 (FIG. 3(a)).

Then, a sub-assembly B31 that includes the sub-assembly A30 and the inner case 14 is assembled. Specifically, the assembly of the cord 13 and the circuit board 12 is inserted from one end of the extension section 140 of the inner case 14 (FIGS. 3(b) and 3(c)), and the small diameter section 142 of the inner case 14 and the coating material 131 of the cord 13 are welded (FIG. 3(d)). The welding method may be such that, as shown in FIG. 3(d), a resin member 143 is additionally molded on the end of the small diameter section 142 of the inner case 14. Alternatively, an appropriate method may be selected by a person skilled in the art from, for example, a method in which the small diameter section 142 of the inner case 14 is laser-welded or compressed with heat without any additional molding, a method in which both the small diameter section 142 of the case 14 and the coating material 131 of the cord 13 are welded, or other methods.

Then, the tubular case 10, the front end member 11, and the sub-assembly B31 are assembled. Specifically, the front end member 11 is accommodated in the tubular case 10 on one end thereof, and the circuit board 12 of the sub-assembly B31 is arranged so as to be in contact with the front end member 11, the electromagnetic coil of the front end member 11 is connected to the circuit board 12 via the coil pin or solder, and then a resin is injected between the inner case 14 and the front end case 110 so as to form the resin section 15 (FIG. 3(e)).

Referring to FIG. 3(f), the tubular case 10 and the large diameter section 141 of the inner case 14 are fixed by hammering, and a resin is injected from a gate opening (not shown) formed in the tubular case 10. Alternatively, the tubular case 10 and the large diameter section 141 of the inner case 14 may be fixed to each other by compression, laser-welding, an adhesive agent, engagement, or the like.

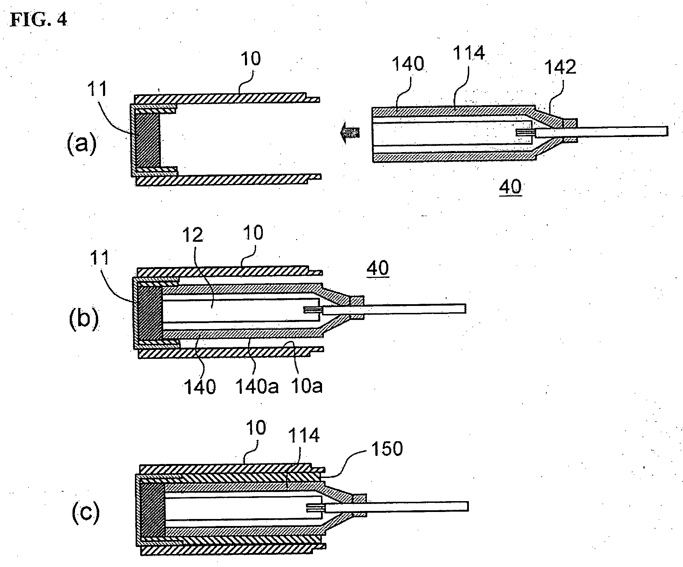

Other embodiments will be described with reference to FIGS. 4. FIGS. 4 are cross-sectional views taken along the line III-III of FIG. 1. Note that the cord is shown in side views. As shown in FIGS. 4(a) to 4(c), an inner case 114 that only includes the extension section 140 and the small diameter section 142 may be used. In this case, similarly to FIGS. 3(b) to 3(d), a sub-assembly B40 is assembled, and then the front end member 11 is accommodated in the tubular case 10 on one end thereof (FIG. 4(a)). Then, the circuit board 12 of the sub-assembly B40 is arranged so as to be in contact with the front end member 11, the electromagnetic coil of the front end member 11 is connected to the circuit board 12 via the coil pin or solder (FIG. 4(b)), and then the resin 150 is injected from between the inner case 114 and the tubular case 10 (FIG. 4(c)).

Furthermore, in this case, one or more grooves may be provided on the circumference of the inner case 114 in the longitudinal axis direction of the tubular case 10 in order to form one or more flow pahts through which a resin is injected. When a resin is injected from the gate opening, a flow of a resin varies depending on the shape or the number of grooves. By varying the shape or the number of grooves resin, it is possible to control the flow.

The distance between the outer circumference 140a of the extension section 140 of the inner case 114 and the inner circumference 10a of the tubular case 10 is preferably 0.8 mm or more to 4.5 mm or less. When the distance is less than 0.8 mm, filling with a resin is difficult, and a section that is not filled with a resin is likely to be generated. Furthermore, when the distance exceeds 4.5 mm, a shrinkage cavity, detachment, and a crack are likely to occur due to a resin contraction stress, and there is the risk that deficiency in water resistance occurs.

### LIST OF REFERENCE NUMERALS

- 1: Proximity sensor
- 10: Tubular case
- 10a: Inner circumference of tubular case
- 11: Front end member
- 110: Front end case
- 111: Detection unit
- 12: Circuit board
- 13: Cord
- 130: Core wire
- 131: Coating material
- 14: Inner case
- 140: Extension section
- 140a: Outer circumference
- 141: Large diameter section
- 142: Small diameter section
- 143: Resin member
- 15: Resin section
- 150: Resin
- 114: Inner case
- 30: Sub-assembly A
- 31: Sub-assembly B
- 40: Sub-assembly B

## Claims

1. An electronic device comprising:
a tubular case (10);
a front end member (11) that is accommodated in the tubular case (10) on one end thereof, and closes the one end;
a circuit board (12) that is fixed to the front end member (11);
a cord (13) that includes a core wire (130) and a coating material (131) for coating the core wire (130), the core wire (130) being exposed from one end of the coating material (131);
wherein the core wire (130) is connected to the circuit board (12),
**characterised in that** the electronic device further comprises
an inner case (14, 114) that is accommodated in the tubular case (10) and is tubular, and whose one end is in contact with the front end member (11), the inner case (14, 114) accommodating the circuit board (12); and
a resin section (15, 150) that watertightly covers a section in which the front end member (11) and the inner case (14, 114) are in contact with each other,
wherein the cord (13) passes through the other end of the inner case (14, 114) and comes out from the other end of the tubular case (10) to the outside of the tubular case (10), and
the inner case (14, 114) and the coating material (131) are welded over the entire circumference of the coating material (131).

2. The electronic device according to claim 1,
wherein the inner case (14, 114) includes:
an extension section (140) that extends cylindrically and accommodates the circuit board (12), and
a small diameter section (142) whose inner diameter decreases in a direction from an edge of the extension section (140) toward the cord (13) that is located through the small diameter section (140), and
the inner diameter of the small diameter section (142) and the coating material (131) are welded over the entire circumference of the coating material (131).

3. The electronic device according to claim 1 or 2,
wherein the inner case (14, 114) includes an extension section (140) that extends cylindrically and accommodates the circuit board (12),
the extension section (140) has, on a part of an outer circumference thereof, a large diameter section (141) whose outer diameter increases toward an inner circumferential surface of the tubular case (10), and
the large diameter section (141) is in contact with the inner circumferential surface of the tubular case (10).

4. The electronic device according to claim 1 or 2,
wherein the inner case (14, 114) includes an extension section (140) that extends cylindrically and accommodates the circuit board (12),
the extension section (140) has, on a part of a cylindrical outer circumference thereof, a large diameter section (141) whose outer diameter increases toward the inner circumferential surface of the tubular case (10), and
the outer diameter of the large diameter section (141) is smaller than an inner diameter of the tubular case (10).

5. The electronic device according to any one of claims 1 to 4,
wherein a space between the inner case (14, 114) and the tubular case (10) is filled with a resin.

6. The electronic device according to any one of claims 1 to 5,
wherein the resin section (15, 150) is made of a thermosetting resin.

7. The electronic device according to any one of claims 1 to 6,
wherein the cord (13) is welded, over the entire circumference of the coating material (131), to the inside of the inner case (14, 114) by 1 mm or more in a direction in which the cord (13) extends to the other end of the tubular case (10).

8. The electronic device according to any one of claims 1 to 6,
wherein a distance between an outer circumferential surface of the inner case (14, 114) and the inner circumferential surface of the tubular case (10) is 0.8 mm or more to 4.5 mm or less.

9. A proximity sensor that is an electronic device according to any of claims 1 to 8,
wherein the front end member (11) serves as a front end case, and
the front end case accommodates a detecting unit that includes a core body on which a coil wire is wound.

## Patentansprüche

1. Elektronische Vorrichtung, welche aufweist:
ein rohrförmiges Gehäuse (10).
ein Stirnseitenelement (11), welches in dem rohrförmigen Gehäuse (10) an einem Ende davon aufgenommen ist und das eine Ende abschließt;
eine Platine (12), welche an dem Stirnseitenelement (11) fixiert ist;
eine Leitung (13), die einen Kerndraht (130) und ein Beschichtungsmaterial (131) zum Beschichten des Kerndrahts (130) umfasst, wobei der Kerndraht (130) an einem Ende des Beschichtungsmaterials (131) freigelegt ist;
wobei der Kerndraht (130) mit der Platine (12) verbunden ist,
**dadurch gekennzeichnet, dass** die elektrische Vorrichtung ferner aufweist:
ein inneres Gehäuse (14, 114), das in dem rohrförmigen Gehäuse (10) aufgenommen ist und rohrförmig ist und dessen eines Ende in Kontakt mit dem Stirnseitenelement (11) ist, wobei das innere Gehäuse (14, 114) die Platine (12) aufnimmt; und
einen Kunststoffabschnitt (15, 150), der einen Abschnitt, in welchem das Stirnseitenelement (11) und das innere Gehäuse (14, 114) miteinander in Kontakt sind, wasserdicht abdeckt,
wobei die Leitung (13) durch das andere Ende des inneren Gehäuses (14, 114) hindurchgeht und an dem anderen Ende des rohrförmigen Gehäuses (10) an die Außenseite des rohrförmigen Gehäuses (10) heraustritt, und
das innere Gehäuse (14, 114) und das Beschichtungsmaterial (131) über den gesamten Umfang des Beschichtungsmaterials (131) verschweißt sind.

2. Elektronische Vorrichtung gemäß Anspruch 1,
wobei das innere Gehäuse (14, 114) umfasst:
einen Erweiterungsabschnitt (140), der sich zylindrisch erstreckt und die Platine (12) aufnimmt, und
einen Klein-Durchmesserabschnitt (142), dessen innerer Durchmesser in einer Richtung von einer Kante des Erweiterungsabschnitts (140) zu der Leitung (13) hin abnimmt, die durch den Klein-Durchmesserabschnitt (140) hindurch lokalisiert ist, und
wobei der innere Durchmesser des Klein-Durchmesserabschnitts (142) und das Beschichtungsmaterial (131) über den gesamten Umfang des Beschichtungsmaterials (131) verschweißt sind.

3. Elektronische Vorrichtung gemäß Anspruch 1 oder 2,
wobei das innere Gehäuse (14, 114) einen Erweiterungsabschnitt (140) umfasst, der sich zylindrisch erstreckt und die Platine (12) aufnimmt,
wobei der Erweiterungsabschnitt (140) auf einem Teil eines äußeren Umfangs davon einen Groß-Durchmesserabschnitt (141) aufweist, dessen äußerer Durchmesser in Richtung einer inneren Umfangsoberfläche des rohrförmigen Gehäuses (10) hin zunimmt, und
wobei der Groß-Durchmesserabschnitt (141) in Kontakt mit der inneren Umfangsoberfläche des rohrförmigen Gehäuses (10) ist.

4. Elektronische Vorrichtung gemäß Anspruch 1 oder 2,
wobei das innere Gehäuse (14, 114) einen Erweiterungsabschnitt (140) umfasst, der sich zylindrisch erstreckt und die Platine (12) aufnimmt,
wobei der Erweiterungsabschnitt (140) auf einem Teil eines zylindrischen äußeren Umfangs davon einen Groß-Durchmesserabschnitt (141) aufweist, dessen äußerer Durchmesser in Richtung der inneren Umfangsoberfläche des rohrförmigen Gehäuses (10) hin zunimmt, und
wobei der äußere Durchmesser des Groß-Durchmesserabschnitts (141) kleiner als ein innerer Durchmesser des rohrförmigen Gehäuses (10) ist.

5. Elektronische Vorrichtung gemäß einem der Ansprüche 1 bis 4,
wobei ein Raum zwischen dem inneren Gehäuse (14, 114) und dem rohrförmigen Gehäuse (10) mit einem Kunststoff gefüllt ist.

6. Elektronische Vorrichtung gemäß einem der Ansprüche 1 bis 5,
wobei der Kunststoffabschnitt (15, 150) aus einem wärmehärtenden Kunststoff hergestellt ist.

7. Elektronische Vorrichtung gemäß einem der Ansprüche 1 bis 6,
wobei die Leitung (13) über den gesamten Umfang des Beschichtungsmaterials (131) an die Innenseite des inneren Gehäuses (14, 114) mittels 1 mm oder mehr in einer Richtung verschweißt ist, in welcher sich die Leitung (13) zu dem anderen Ende des rohrförmigen Gehäuses (10) erstreckt.

8. Elektronische Vorrichtung gemäß einem der Ansprüche 1 bis 6,
wobei ein Abstand zwischen einer äußeren Umfangsoberfläche des inneren Gehäuses (14, 114) und der inneren Umfangsoberfläche des rohrförmigen Gehäuses (10) 0,8 mm oder mehr bis 4,5 mm oder weniger ist.

9. Annäherungssensor, der eine elektronische Vorrichtung gemäß einem der Ansprüche 1 bis 8 ist,
wobei das Stirnseitenelement (11) als ein Stirnseitengehäuse dient, und
das Stirnseitengehäuse eine Erfassungseinheit aufnimmt, die einen Kernhauptteil umfasst, in welchem ein Spulendraht gewickelt ist.

## Revendications

1. Dispositif électronique, comprenant :
un boîtier tubulaire (10) ;
un élément d'extrémité avant (11) qui est logé dans le boîtier tubulaire (10) à une extrémité de celui-ci, et qui ferme cette extrémité ;
une carte de circuits imprimés (12) qui est fixée à l'élément d'extrémité avant (11) ;
un cordon (13) qui comporte un fil d'âme (130) et un matériau de revêtement (131) destiné à revêtir le fil d'âme (130), le fil d'âme (130) étant exposé depuis une extrémité du matériau de revêtement (131) ;
dans lequel le fil d'âme (130) est connecté à la carte de circuits imprimés (12),
**caractérisé en ce que** le dispositif électronique comprend en outre :
un boîtier intérieur (14, 114) qui est logé dans le boîtier tubulaire (10), qui est tubulaire et dont une extrémité est en contact avec l'élément d'extrémité avant (11), le boîtier intérieur (14, 114) logeant la carte de circuits imprimés (12) ; et
une section en résine (15, 150) qui recouvre de manière étanche à l'eau une section dans laquelle l'élément d'extrémité avant (11) et le boîtier intérieur (14, 114) sont au contact l'un de l'autre,
dans lequel le cordon (13) passe à travers l'autre extrémité du boîtier intérieur (14, 114) et sort par l'autre extrémité du boîtier tubulaire (10) hors du boîtier tubulaire (10), et
le boîtier intérieur (14, 114) et le matériau de revêtement (131) sont soudés sur toute la circonférence du matériau de revêtement (131).

2. Dispositif électronique selon la revendication 1,
dans lequel le boîtier intérieur (14, 114) comporte :
une section de prolongement (140) qui s'étend de manière cylindrique et loge la carte de circuits imprimés (12), et
une section de petit diamètre (142) dont le diamètre intérieur diminue dans une direction allant d'un bord de la section de prolongement (140) vers le cordon (13) qui se trouve à travers la section de petit diamètre (142), et
le diamètre intérieur de la section de petit diamètre (142) et le matériau de revêtement (131) sont soudés sur toute la circonférence du matériau de revêtement (131).

3. Dispositif électronique selon la revendication 1 ou 2,
dans lequel le boîtier intérieur (14, 114) comporte une section de prolongement (140) qui s'étend de façon cylindrique et loge la carte de circuits imprimés (12),
la section de prolongement (140) présente, sur une partie de sa circonférence extérieure, une section de grand diamètre (141) dont le diamètre extérieur augmente vers une surface circonférentielle intérieure du boîtier tubulaire (10), et
la section de grand diamètre (141) est au contact de la surface circonférentielle intérieure du boîtier tubulaire (10).

4. Dispositif électronique selon la revendication 1 ou 2,
dans lequel le boîtier intérieur (14, 114) comporte une section de prolongement (140) qui s'étend de façon cylindrique et loge la carte de circuits imprimés (12),
la section de prolongement (140) présente, sur une partie de sa circonférence cylindrique extérieure, une section de grand diamètre (141) dont le diamètre extérieur augmente vers la surface circonférentielle intérieure du boîtier tubulaire (10), et
le diamètre extérieur de la section de grand diamètre (141) est inférieur à un diamètre intérieur du boîtier tubulaire (10).

5. Dispositif électronique selon l'une quelconque des revendications 1 à 4,
dans lequel un espace entre le boîtier intérieur (14, 114) et le boîtier tubulaire (10) est rempli d'une résine.

6. Dispositif électronique selon l'une quelconque des revendications 1 à 5,
dans lequel la section en résine (15, 150) est constituée d'une résine thermodurcissable.

7. Dispositif électronique selon l'une quelconque des revendications 1 à 6,
dans lequel le cordon (13) est soudé, sur toute la circonférence du matériau de revêtement (131), à l'intérieur du boîtier intérieur (14, 114) sur 1 mm ou plus, dans une direction dans laquelle le cordon (13) s'étend vers l'autre extrémité du boîtier tubulaire (10).

8. Dispositif électronique selon l'une quelconque des revendications 1 à 6,
dans lequel une distance entre une surface circonférentielle extérieure du boîtier intérieur (14, 114) et la surface circonférentielle intérieure du boîtier tubulaire (10) va de 0,8 mm ou plus à 4,5 mm ou moins.

9. Capteur de proximité qui est un dispositif électronique selon l'une quelconque des revendications 1 à 8,
dans lequel l'élément d'extrémité avant (11) sert de boîtier d'extrémité avant, et
le boîtier d'extrémité avant loge une unité de détection qui comporte un corps central sur lequel est enroulé du fil à bobiner.
